# EUROPÄISCHE PATENTSCHRIFT

(11) **EP 2 342 771 B1**
(45) Veröffentlichungstag und Bekanntmachung des Hinweises auf die Patenterteilung: **11.05.2016**
(21) Anmeldenummer: 09771272.3
(22) Anmeldetag: 16.10.2009
(51) Int. Cl.: H01L 51/52, H01L 51/56

(54) **VERFAHREN ZUR HERSTELLUNG EINES ORGANISCHEN STRAHLUNGSEMITTIERENDEN BAUELEMENTS**
METHOD FOR PRODUCING AN ORGANIC RADIATION-EMITTING COMPONENT
PROCÉDÉ DE PRODUCTION D'UN COMPOSANT ORGANIQUE ÉMETTEUR DE RAYONNEMENT

(30) Priorität: 07.11.2008 DE 102008056370
(43) Veröffentlichungstag der Anmeldung: 13.07.2011
(73) Patentinhaber: OSRAM OLED GmbH, 93049 Regensburg (DE)
(72) Erfinder: GÄRDITZ, Christoph, 93051 Regensburg (DE); WEISS, Oliver, 69221 Dossenheim (DE); PÄTZOLD, Ralph, 91154 Roth (DE); SARFERT, Wiebke, 91074 Herzogenaurach (DE)
(74) Vertreter: Epping - Hermann - Fischer
(86) Internationale Anmeldenummer: PCT/DE2009/001446
(87) Internationale Veröffentlichungsnummer: WO 2010/051789

(56) Entgegenhaltungen:
- EP-A2- 1 830 421
- DE-A1-102007 006 348
- US-A1- 2004 212 296
- US-A1- 2006 007 552
- US-A1- 2007 013 291
- US-A1- 2008 165 315

## Beschreibung

Es wird ein Verfahren zur Herstellung eines organischen strahlungsemittierenden Bauelements angegeben.

Organische Leuchtdioden (OLEDs) für Beleuchtungs- und Signalzwecke verlangen nach immer höheren Leuchtdichten bei gleichzeitig hohen Effizienzen und Lebensdauern. Bei bekannten OLEDs wird versucht, dies durch die Optimierung und Weiterentwicklung der Emittermaterialien und des Schichtaufbaus der OLEDs zu erreichen.

Die Druckschrift EP 1830421 A2 offenbart ein Verfahren zur Verbesserung der Lichtextraktionseffizienz eines Licht emittierenden Bauelements mit einer organischen Licht emittierenden Schicht zwischen zwei Elektroden, bei dem feine Partikel auf die Oberfläche einer der Elektroden mittels einer Trockensprühmethode oder einer Feuchtsprühmethode aufgesprüht werden. Die feinen Partikel bestehen entweder aus einem organischen oder einem anorganischen Material und bleiben als Auskoppelstruktur zurück, wobei im Fall, dass ein Lösungsmittel verwendet wird, dieses verdampft.

Die Druckschrift US 2006/0007552 A1 beschreibt ein organisches elektrolumineszierendes Bauelement, das auf einer Lichtauskoppelfläche eine Schicht mit Mikrolinsen aufweist, die durch Aufsprühen hergestellt werden, wobei sich Tropfen einer Flüssigkeit durch eine geeignete Wahl des Substrats, auf das die Tropfen aufgesprüht werden, in Form von Mikrolinsen auf der Oberfläche ablagern und dort ausgehärtet werden.

Die Druckschrift US 2008/0165315 A1 beschreibt ein Licht emittierendes Bauelement, das auf einer einer elektrolumineszierenden Schicht abgewandten Seite eines Substrats eine Schicht mit pyramidenartigen Strukturen aufweist, die beispielsweise mittels Aufbringen von Tropfen hergestellt werden können.

Es ist die Aufgabe der Erfindung, ein Verfahren zur Herstellung eines organischen strahlungsemittierenden Bauelements mit einer organischen strahlungsemittierenden Schichtenfolge anzugeben.

Diese Aufgabe wird durch ein Verfahren nach Anspruch 1 gelöst. Vorteilhafte Ausführungsformen und Weiterbildungen des Verfahrens sind in den abhängigen Ansprüchen gekennzeichnet und gehen weiterhin aus der nachfolgenden Beschreibung und den Zeichnungen hervor.

Ein Verfahren zur Herstellung eines organischen strahlungsemittierenden Bauelements gemäß einer Ausführungsform umfasst insbesondere die Schritte:
A) Bereitstellen einer organischen strahlungsemittierenden Schichtenfolge mit zumindest einer organischen funktionellen Schicht, die geeignet ist, im Betrieb elektromagnetische Strahlung abzustrahlen, und einer transparenten Schicht,
B) Aufbringen einer transparenten Strahlungsauskoppelschicht mit einer Oberflächenstruktur auf einer der zumindest einen funktionellen Schicht abgewandten Oberfläche der transparenten Schicht mittels Aufsprühen.

Dass eine Schicht oder ein Element "auf" oder "über" einer anderen Schicht oder einem anderen Element angeordnet oder aufgebracht ist, kann dabei hier und im Folgenden bedeuten, dass die eine Schicht oder das eine Element unmittelbar in direktem mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht beziehungsweise zwischen dem einen und dem anderen Element angeordnet sein.

Dass eine Schicht oder ein Element "zwischen" zwei anderen Schichten oder Elementen angeordnet ist, kann hier und im Folgenden bedeuten, dass die eine Schicht oder das eine Element unmittelbar in direktem mechanischen und/oder elektrischen Kontakt oder in mittelbarem Kontakt zur einen der zwei anderen Schichten oder Elementen und in direktem mechanischen und/oder elektrischen Kontakt oder in mittelbarem Kontakt zur anderen der zwei anderen Schichten oder Elementen angeordnet ist. Dabei können bei mittelbarem Kontakt dann weitere Schichten und/oder Elemente zwischen der einen und zumindest einer der zwei anderen Schichten beziehungsweise zwischen dem einen und zumindest einem der zwei anderen Element angeordnet sein.

Die Bezeichnungen "Strahlung", "elektromagnetische Strahlung" und "Licht" bedeuten hier und im Folgenden elektromagnetische Strahlung mit zumindest einer Wellenlänge beziehungsweise einer spektralen Komponente in einem infraroten bis ultravioletten Wellenlängenbereich. Insbesondere kann infrarotes, sichtbares und/oder ultraviolettes Licht bezeichnet sein.

Bei bekannten OLEDs können die größten Verlustfaktoren hinsichtlich der Effizienz durch die Wellenleitung von Licht innerhalb organischer Schichten mit einem Verlustfaktor von etwa 40 bis 50% und transparenten Schichten wie etwa einem Glassubstrat mit einem Verlustfaktor von etwa 20 bis 30% gegeben sein, wobei die Verlustfaktoren auf die Gesamtleistung des in der OLED erzeugten Lichts bezogen sind. Mittels des hier beschriebenen Verfahrens kann ein organisches strahlungsemittierendes Bauelement hergestellt werden, das diese Verlustfaktoren zumindest teilweise vermindern kann. Dabei kann mit Vorteil insbesondere aufgrund des Aufsprühens eine geeignete Strahlungsauskoppelschicht mit einer Oberflächenstruktur erzeugt werden, die die Auskopplung der in der organischen strahlungsemittierenden Schichtenfolge erzeugten elektromagnetischen Strahlung aus dem organischen strahlungsemittierenden Bauelement erhöht.

Weiterhin kann es möglich sein, dass durch das hier beschriebene Verfahren ein organisches strahlungsemittierendes Bauelement geschaffen werden kann, bei dem ein Großteil des bei bekannten OLEDs wellengeleiteten Lichts ausgekoppelt und damit nutzbar gemacht werden kann. Beispielsweise kann die verbesserte Auskopplung durch Lichtstreuprozesse an der Oberflächenstruktur der Strahlungsauskoppelschicht bewirkt werden.

Das organische strahlungsemittierende Bauelement mit der organischen strahlungsemittierenden Schichtenfolge kann insbesondere eine organische lichtemittierende Diode (OLED) umfassen oder als solche ausgeführt sein. Dazu kann die im Verfahrensschritt A bereitgestellte organischen strahlungsemittierende Schichtenfolge die als aktiven Bereich ausgebildete zumindest eine organische funktionelle Schicht aufweisen, die geeignet ist, im Betrieb des organischen elektronischen Bauelements durch Rekombination von Elektronen und Löchern elektromagnetische Strahlung zu erzeugen.

Die im Verfahrensschritt A bereitgestellte organische strahlungsemittierende Schichtenfolge kann beispielsweise eine erste Elektrode aufweisen, die auf einem Substrat aufgebracht ist oder die beispielsweise auch als Folie bereitgestellt wird. Über der ersten Elektrode kann die zumindest eine organische funktionelle Schicht oder eine Mehrzahl von funktionellen Schichten aus organischen Materialien aufgebracht werden. Die zumindest eine organische funktionelle Schicht oder die Mehrzahl der funktionellen Schichten können dabei beispielsweise Elektronentransportschichten, Lochblockierschichten, elektrolumineszierende Schichten, Elektronenblockierschichten und/oder Lochtransportschichten aufweisen oder als solche ausgeführt sein. Über der organischen funktionellen Schicht oder der Mehrzahl organischer funktioneller Schichten kann eine zweite Elektrode aufgebracht sein.

Beispielsweise kann das Substrat Glas, Quarz, Kunststofffolien, Metall, Metallfolien, Siliziumwafer oder ein anderes geeignetes Substratmaterial umfassen. Ist das organische strahlungsemittierende Bauelement und insbesondere die organische strahlungsemittierende Schichtenfolge als so genannter "Bottom-Emitter" ausgeführt, kann die in der organischen strahlungsemittierenden Schichtenfolge erzeugte elektromagnetische Strahlung durch das Substrat abgestrahlt werden. Das Substrat kann dazu eine Transparenz für zumindest einen Teil der in der zumindest einen organischen funktionellen Schicht erzeugten elektromagnetischen Strahlung aufweisen. Insbesondere kann in diesem Fall das Substrat die transparente Schicht mit der von der zumindest einen organischen funktionellen Schicht abgewandten Oberfläche sein, auf der im Verfahrensschritt B die Strahlungsauskoppelschicht durch Aufsprühen aufgebracht wird.

In der Bottom-Emitter-Konfiguration kann weiterhin auch die erste Elektrode eine Transparenz für zumindest einen Teil der durch die zumindest eine organische funktionelle Schicht erzeugte elektromagnetische Strahlung aufweisen. Damit kann auch die erste Elektrode die transparente Schicht im Sinne des hier beschriebenen Verfahrens sein, wobei die Strahlungsauskoppelschicht dann auch vor dem Aufbringen der ersten Elektrode zwischen dem Substrat und der ersten Elektrode aufgebracht werden kann.

Eine transparente erste Elektrode, die als Anode ausgeführt sein kann und somit als löcherinjizierendes Material dient, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Die erste Elektrode kann weiterhin ein organisches elektrisch leitendes Material ausgewählt aus einer Gruppe aufweisen, die gebildet wird durch Polyacetylen, Polyphenylen, Polythiophen, Polypyrrol, Polyvinylen und Polyanilin und Copolymere und Mischungen davon. Besonders bevorzugt kann die zweite Schicht Polyethylendioxythiophen ("PEDOT") und/oder Polyanilin ("PANI") aufweisen. Weiterhin kann die erste Elektrode auch organische kleine Moleküle eines oder mehrerer Materialien ausgewählt aus einer Gruppe aufweisen, die gebildet wird durch Phenanthrolinderivate, Imidazolderivate, Triazolderivate, Oxadiazolderivate, Phenyl-haltige Verbindungen, Verbindungen mit kondensierten Aromaten, Carbazol-haltige Verbindungen, Fluorenderivate, Spirofluorenderivate und Pyridin-haltige Verbindungen sowie Kombinationen aus zumindest zwei oder mehreren der genannten Materialien.

Darüber hinaus kann die erste Elektrode Nanopartikel beispielsweise in Form von Kohlenstoffnanoröhrchen und/oder Fullerenen aufweisen. Die organischen kleinen Moleküle und/oder die Nanopartikel können beispielsweise als Dotierung eines elektrisch leitenden oder in undotiertem Zustand elektrisch isolierenden Matrixmaterials ausgeführt sein, durch die die elektrische Leitfähigkeit des Matrixmaterials erhöht werden kann.

Die zumindest eine organische funktionelle Schicht oder die Mehrzahl der organischen funktionellen Schichten können organische Polymere, organische Oligomere, organische Monomere, organische kleine, nicht-polymere Moleküle ("small molecules") oder Kombinationen daraus aufweisen. Insbesondere kann es vorteilhaft sein, wenn die organische strahlungsemittierende Schichtenfolge eine funktionelle Schicht aufweist, die als Lochtransportschicht ausgeführt ist, um eine effektive Löcherinjektion in eine elektrolumineszierende Schicht oder einen elektrolumineszierenden Bereich zu ermöglichen. Als Polymermaterialien für eine Lochtransportschicht können sich beispielsweise tertiäre Amine, Carbazolderivate, leitendes Polyanilin oder Polyethylendioxythiophen als vorteilhaft erweisen. Als Small-Molecule-Materialien können beispielsweise N,N'-Bis(3-methylphenyl)-N,N'-bis(phenyl)-benzidin (TPD), N,N'-Bis(naphthalen-1-yl)-N,N'-bis(phenyl)-benzidin (NPB) oder 4,4',4"-Tris(N,N-diphenyl-amino)-triphenylamine (TDATA) aufgedampft werden, die als p-Dotierstoff eines oder mehrere der folgenden Materialien aufweisen können: ein organisches Material wie etwa (F₄TCNQ), ein Halogenid wie etwa FeCl₃ oder SbCl₅ oder ein Metalloxid wie etwa WO₃.

Weiterhin kann es vorteilhaft sein, wenn die zumindest eine funktionelle Schicht als aktiver Bereich umfassend zumindest eine elektrolumineszierende Schicht ausgeführt ist. Als Materialien hierzu eignen sich beispielsweise polymere Materialien, die eine Strahlungsemission aufgrund von Fluoreszenz oder Phosphoreszenz aufweisen, beispielsweise Polyfluoren, Polythiophen oder Polyphenylen oder Derivate, Verbindungen, Mischungen oder Copolymere davon. Als Small-Molecule-Materialien eignen sich beispielsweise Tris(8-hydroxyquinoline)aluminium (Alq₃), Tris[2-(2-pyridinyl)phenyl-C,N]-iridium (Ir(ppy)₃) oder Bis(4,6-difluorophenylpyridinato-N,C2)picolinatoiridium (FIrpic). Abhängig von den Materialien in den funktionellen Schichten kann die erzeugte erste Strahlung einzelne Wellenlängen oder Bereiche oder Kombinationen daraus aus dem ultravioletten bis rotem Spektralbereich aufweisen.

Die zweite Elektrode kann als Kathode ausgeführt sein und somit als elektroneninjizierendes Material dienen. Als Kathodenmaterial können sich unter anderem insbesondere Aluminium, Barium, Indium, Silber, Gold, Magnesium, Kalzium oder Lithium sowie Verbindungen, Kombinationen und Legierungen davon als vorteilhaft erweisen. Alternativ oder zusätzlich kann die zweite Elektrode auch eines der oben genannten TCOs oder eine Mehrschichtkombination mit Metall und TCO-Schichten aufweisen. Insbesondere kann die Kathode auch eine Schicht mit einem elektroneninjizierenden Material wie etwa einem Metall oder einer Metallverbindung mit geringer Austrittsarbeit aufweisen, beispielsweise Ba, Ca, Mg, LiF, CsF oder NaF, sowie eine einen Deckkontakt bildende Schicht mit Al, Ag und/oder Au zur Kontaktierung.

Zusätzlich oder alternativ kann die zweite Elektrode auch transparent ausgeführt sein und/oder die erste Elektrode kann als Kathode und die zweite Elektrode als Anode ausgeführt sein. Das bedeutet insbesondere, dass das organische strahlungsemittierende Bauelement und insbesondere die organische strahlungsemittierende Schichtenfolge auch als "Top-Emitter" ausgeführt sein können. Dabei kann die transparente Schicht, auf der im Verfahrensschritt B die Strahlungsauskoppelschicht mittels Aufsprühen aufgebracht wird, die zweite transparente Elektrode umfassen oder sein.

Die erste und/oder die zweite Elektrode können jeweils großflächig ausgebildet sein. Dadurch kann im Falle einer als OLED ausgebildeten organischen strahlungsemittierenden Schichtenfolge eine großflächige Abstrahlung der erzeugten elektromagnetischen Strahlung ermöglicht werden. "Großflächig" kann dabei bedeuten, dass das organische strahlungsemittierende Bauelement und insbesondere die organische strahlungsemittierende Schichtenfolge eine Fläche von größer oder gleich einigen Quadratmillimetern, bevorzugt größer oder gleich einem Quadratzentimeter und besonders bevorzugt größer oder gleich einem Quadratdezimeter aufweist. Alternativ oder zusätzlich können die erste und/oder die zweite Elektrode zumindest in Teilbereichen strukturiert ausgebildet sein. Dadurch kann eine strukturierte Abstrahlung der erzeugten elektromagnetischen Strahlung ermöglicht werden, etwa in Form eines Displays mit Pixeln oder in Form von Piktogrammen.

Darüber hinaus kann das organische strahlungsemittierende Bauelement eine Verkapselung über der organischen strahlungsemittierenden Schichtenfolge aufweisen, um beispielsweise für die Elektroden und die organische Schichtenfolge einen Schutz vor Feuchtigkeit und/oder oxidierenden Substanzen wie etwa Sauerstoff zu erreichen. Die Verkapselung kann dabei eine oder mehrere Schichten umfassen, wobei die Schichten der Verkapselung beispielsweise Planarisierungsschichten, Barriereschichten, Wasser und/oder Sauerstoff absorbierende Schichten, Verbindungsschichten oder Kombinationen daraus sein können. Die Verkapselung kann beispielsweise eine Abdeckung in Form einer Kappe, insbesondere einer freitragenden Kappe, und/oder eine Schicht oder Schichtenfolge auf beziehungsweise über der zweiten Elektrode aufweisen. Geeignete Materialien können beispielsweise Glas, Kunststoffe, Metalle, Metalloxide, Nicht-Metall-Oxide oder Nicht-Metall-Nitride wie etwa SiOₓ oder SiNₓ, Keramiken oder Kombinationen daraus aufweisen oder sein. Weiterhin kann die Abdeckung auch als Laminat ausgeführt sein. Insbesondere kann die Verkapselung auch transparent sein, besonders bevorzugt in Verbindung mit einer als Top-Emitter ausgeführten OLED, so dass die transparente Schicht, auf der im Verfahrensschritt B die Strahlungsauskoppelschicht mittels Aufsprühen aufgebracht wird, die Verkapselung umfassen kann oder durch diese gebildet sein kann.

Die transparente Schicht kann somit beispielsweise ein transparentes Substrat, eine transparente Elektrode und/oder eine transparente Verkapselung aufweisen oder sein.

"Aufsprühen" (auch "spray coating") kann hier und im Folgenden insbesondere ein Verfahren bezeichnen, bei dem eine Flüssigkeit zu kleinen Tropfen zerstäubt wird, die beispielsweise mittels einer Düse auf eine Oberfläche aufgebracht werden können. Insbesondere können die Tropfen durch das Zerstäuben eine mittlere Größe aufweisen. Die einzelnen Tropfen des durch die Düse erzeugten Tropfenensembles können eine Größe aufweisen, die einer statistischen Verteilung um die mittlere Größe herum entspricht. Die mittlere Größe der Tropfen sowie die statistische Verteilung der Tropfengrößen können dabei im Bereich von einigen hundert Nanometern liegen und vom Zerstäubungsverfahren der Flüssigkeit sowie von Eigenschaften der Flüssigkeit wie etwa deren Viskosität und/oder deren Bestandteile in Form von Materialien und Gemischen in flüssiger Phase, in Form einer Lösung, einer Suspension und/oder einer Emulsion abhängen.

Weiterhin kann hier und im Folgenden "Flüssigkeit" ein Material in einer flüssigen Phase sowie ein Gemisch oder eine Lösung aus mehreren Materialien in flüssiger Phase bezeichnen. Weiterhin kann eine Flüssigkeit eine Lösung, Suspension oder Emulsion von flüssigen und festen Materialien umfassen oder sein.

Bei dem hier beschriebenen Verfahren wird vor dem Verfahrensschritt B eine Flüssigkeit bereitgestellt, die die aufzusprühende Materialien zur Herstellung der Strahlungsauskoppelschicht aufweist und die insbesondere, wie weiter unten beschrieben ist, nichtflüchtige Materialien aufweist, die auf der Oberfläche der transparenten Schicht der organischen strahlungsemittierenden Schichtenfolge verbleiben. Weiterhin kann die Flüssigkeit noch weitere Bestandteile, bevorzugt flüchtige Bestandteile, aufweisen wie etwa ein oder mehrere Lösungsmittel und/oder ein oder mehrere flüssige Suspensionsmedien und/oder ein oder mehrere Emulgatoren und/oder ein oder mehrere Binder und/oder weitere flüssige Materialien.

Um eine möglichst effiziente Strahlungsauskoppelschicht auf der transparenten Schicht der organischen strahlungsemittierenden Schichtenfolge herzustellen, kann es erforderlich sein, dass die Oberflächenstruktur der Strahlungsauskoppelschicht Strukturen in einer Größenordnung, das heißt mit einem Flächenanteil auf der Oberfläche der transparenten Schicht und/oder mit einer Höhe, von etwa einer halben Wellenlänge der in der organischen strahlungsemittierenden Schichtenfolge erzeugten elektromagnetischen Strahlung bis zu etwa der dreifachen Wellenlänge zu erzeugen. Besonders bevorzugt weisen die Strukturen der Oberflächenstruktur eine Größe von größer oder gleich etwa einer halben bis einer Wellenlänge und kleiner oder gleich einer Wellenlänge plus einigen 100 Nanometern auf. Das kann beispielsweise bedeuten, dass die Strukturen der Oberflächenstruktur eine Größe von größer oder gleich 200 Nanometer und kleiner oder gleich 1 Mikrometer aufweisen können.

Insbesondere kann die Oberflächenstruktur der Strahlungsauskoppelschicht Strukturen mit einer mittleren Größe aufweisen, wobei die jeweiligen Größen der einzelnen Strukturen eine statistische Verteilung aufweisen können, wie vorab in Verbindung mit der statistischen Verteilung der Größe der Tropfen beschrieben ist.

Weiterhin können durch eine möglichst unregelmäßige Verteilung der Strukturen und ihrer Größen störende Effekte wie etwa Moire-Effekte vermieden werden, wie sie durch zu regelmäßige Strukturen in den genannten Größenordnungen erzeugt werden könnten. Daher kann es durch das Aufsprühen mit Vorteil möglich sein, eine Strahlungsauskoppelschicht mit einer Oberflächenstruktur herzustellen, die Strukturen mit einer möglichst unregelmäßigen Ortsverteilung aufweist. Das kann insbesondere bedeuten, dass im Mittel jeweils benachbarte Strukturen der Oberflächenstruktur einen mittleren Abstand voneinander aufweisen, wobei einzelne jeweils benachbarte Strukturen einen tatsächlichen Abstand voneinander aufweisen können, der einer möglichst breiten statistischen Verteilung wie vorab in Verbindung mit der Tropfengröße beschrieben entspricht.

Weiterhin können auch die Tropfen der Flüssigkeit, die auf die transparente Schicht zur Erzeugung der Strahlungsauskoppelschicht aufgesprüht werden, Größen aufweisen, die nach dem Aufsprühen auf die Oberfläche die in den in Verbindung mit der Strahlungsauskoppelschicht genannten Größenbereiche aufweisen.

Im Gegensatz zum Aufsprühen sind Strukturen in der vorab beschriebenen Größenordnung und den vorab beschriebenen Größenbereichen mittels anderer bekannter Strukturierungsmöglichkeiten nicht oder nur unter großem technischem Aufwand herstellbar. So sind generell Strukturierungsmöglichkeiten wie das Aufrauen von Oberflächen durch Sandstrahlen oder Ätzen bekannt. Durch Sandstrahlen können aber mit vernünftigem technischem Aufwand nur Strukturen erzeugt werden, die weit größer als die vorab genannten Größenbereiche sind. Auch mittels Ätzen, beispielsweise durch Ätzmasken, können Strukturen in den genannten Größenbereichen technisch nur sehr schwer und aufwändig hergestellt werden. Weiterhin sind diese Verfahren abtragende Verfahren, die hohe Anforderungen an die Prozessverträglichkeit der zu bearbeitenden Bauelemente stellen. Weiterhin sind auch auftragende Verfahren wie etwa Rakeln oder Drucken bekannt, bei denen üblicherweise aber ebenfalls keine Strukturen herstellbar sind, die in den genannten Größenbereichen liegen und die gleichzeitig eine unregelmäßige, statistische Größen- und Ortsverteilung aufweisen, wie dies durch Aufsprühen möglich ist. Andere Verfahren wie etwa das Aufbringen von bereits fertig gestellten Folien mit Streustrukturen unter Verwendung eines optischen Gels oder Klebers sind zwar bekannt, jedoch sind derartige Verfahren neben den vorab genannten Nachteilen durch die zusätzlichen Prozessschritte und Materialien auch sehr kostenintensiv.

Insbesondere kann im Verfahrensschritt B die Strahlungsauskoppelschicht in Form von einzelnen Tropfen aufgesprüht werden, die individuell auf der Oberfläche der transparenten Schicht unter Ausbildung der Strahlungsauskoppelschicht mit der Oberflächenstruktur trocknen können. "Trocknen" kann hier und im Folgenden einen Prozess bezeichnen, bei dem ein Anteil der Flüssigkeit eines Tropfens durch Verdampfen oder Verdunsten aus dem auf der Oberfläche aufgebrachten Tropfen entfernt wird und/oder durch reaktive oder absorptive Effekte an die Oberfläche oder in das Material der transparenten Schicht gebunden wird, so dass der verbleibende Rest des Tropfens einen festen Rückstand auf der Oberfläche bildet. Diejenigen Bestandteile der vor dem Verfahrensschritt B bereitgestellten Flüssigkeit, die nach dem Trocknen nicht als Rückstand auf der Oberfläche verbleiben, können hier und im Folgenden als "flüchtige Bestandteile" bezeichnet werden.

"Individuell trocknen" kann hier und im Folgenden bedeuten, dass ein Tropfen nach dem Aufsprühen auf die Oberfläche quasi isoliert von möglichen anderen Tropfen auf der Oberfläche trocknet, so dass sich insbesondere auf der Oberfläche mehrere Tropfen vor dem Trocknen nicht zu einem größeren Tropfen verbinden können.

Weiterhin kann im Verfahrensschritt B insbesondere ein vernetzbares Material in einer flüssigen Phase, einer Lösung, einer Suspension oder einer Kombination daraus in Form von Tropfen aufgebracht werden, wobei mittels Trocknen und/oder Vernetzen des Materials die Strahlungsauskoppelschicht mit der Oberflächenstruktur gebildet wird. Das Vernetzen kann dabei durch eine oder mehrere chemische Reaktionen von Bestandteilen des Tropfens miteinander und/oder mit der Oberfläche erfolgen, wobei die Reaktion nach dem Auftragen eines Tropfens selbstinitiiert durch die Materialien sein kann und/oder von außen initiiert werden kann durch Einwirkung von Wärme, Licht, etwa UV-Licht, oder Teilchenstrahlung, etwa Elektronen.

Beispielsweise können die Tropfen individuell auf der Oberfläche trocknen und anschließend gemeinsam vernetzt und ausgehärtet werden. Alternativ dazu kann jeder Tropfen während oder nach dem individuellen Trocknen unabhängig von anderen Tropfen vernetzt und ausgehärtet werden.

Weiterhin können die Tropfen beim Trocknen Rückstände ausbilden. Die Rückstände werden dabei durch alle Bestandteile der aufgesprühten Flüssigkeit gebildet, die nicht durch das Trocknen aus den Tropfen entfernt werden, also durch alle nichtflüchtigen Bestandteile gemäß der obigen Beschreibung. Dabei kann es während des Trocknens zu einer Diffusion der nichtflüchtigen Bestandteile der als Tropfen aufgesprühten Flüssigkeit kommen. Die Diffusion kann beispielsweise durch Unterschiede in der Oberflächenspannung eines aufgesprühten Tropfens durch unterschiedliche Trocknungsraten im Tropfen bewirkt werden. Die unterschiedlichen Trocknungsraten können beispielsweise bei verdampfenden oder verdunstenden flüchtigen Bestandteilen durch unterschiedliche Verdampfungsraten in verschiedenen Bereichen eines Tropfens hervorgerufen werden. Dadurch kann innerhalb eines trocknenden Tropfens eine Diffusion von Flüssigkeit, also flüchtigen und nichtflüchtigen Bestandteilen, von ersten Bereichen mit geringer Verdampfungsrate zu zweiten Bereichen mit höherer Verdampfungsrate hin auftreten, wodurch sich vermehrt nichtflüchtige Bestandteile in den zweiten Bereichen ansammeln können. Bei einem auf der Oberfläche der transparenten Schicht aufgesprühten Tropfen kann ein erster Bereich mit niedriger Verdampfungsrate aufgrund einer höheren Oberflächenspannung beispielsweise einen Mittenbereich des Tropfens sein, während Randbereiche des Tropfens zweite Bereiche mit vergleichsweise höherer Verdampfungsrate aufgrund einer dort vorliegen könnenden niedrigeren Oberflächenspannung sein können. Derartige Diffusionseffekte können auch als so genannter Marangoni- oder Kaffeefleckeffekt bezeichnet werden.

Die Diffusionsrate beziehungsweise -geschwindigkeit innerhalb eines trocknenden Tropfens kann beispielsweise durch die Mischungsanteile der flüchtigen und nichtflüchtigen Bestandteile, deren Viskositäten, Polaritäten und/oder durch die Verdampfungseigenschaften wie etwa die Siedpunkte der flüchtigen Bestandteile und/oder durch deren Reaktionseigenschaften mit der Oberfläche der transparenten Schicht einstellbar sein. Wenn beispielsweise die Bestandteile eines Tropfens derart ausgewählt sind, dass die Viskosität des trocknenden Tropfens nur langsam während des Trocknens zunimmt, können die nichtflüchtigen Bestandteile ausreichend Zeit haben, in die oben genannten zweiten Bereiche zu diffundieren, wodurch es in diesen Bereichen zu einer großen Ansammlung beziehungsweise einem im Vergleich zu den ersten Bereichen größeren Rückstand von nichtflüchtigen Bestandteilen kommen kann.

Besonders bevorzugt können die Tropfen beim Trocknen Rückstände bilden, die ein Höheprofil mit einer prismenartigen, pyramidenartigen, meniskenartigen oder linsenartigen Form oder einer Kombination daraus aufweisen. Das kann bedeuten, dass ein Tropfen alleine eine solche Form ausbilden kann oder auch dass zwei oder mehrere benachbart aufgesprühte und individuell getrocknete Tropfen zusammen eine derartige Form ausbilden können. Insbesondere können beispielsweise zwei oder mehrere aneinander angrenzende meniskenartige Rückstände in dem Bereich, in dem sie aneinander angrenzen, eine pyramiden- oder prismenartige Struktur bilden.

Da wie oben beschrieben die Tropfen mit einer statistischen Größenverteilung und einer statistischen Ortsverteilung unregelmäßig auf der Oberfläche der transparenten Schicht aufgesprüht werden können, können die vorab genannten Formen die Oberflächenstruktur mit Strukturen mit ebenfalls unregelmäßiger Verteilung bilden. Weiterhin können Tropfen auch teilweise oder ganz überlappend und damit teilweise oder ganz über bereits aufgesprühten und getrockneten Tropfen aufgesprüht werden, wodurch durch den oben beschriebene Effekt eine weitere Erhöhung der erzeugten Strukturen der Oberflächenstruktur erreicht werden kann.

Weiterhin können durch das Trocknen der Tropfen auf der Oberfläche Rückstände in Form von Strukturen mit einem Verhältnis der belegten Fläche jedes Rückstands auf der Oberfläche zu seiner Höhe ("aspect ratio", "Grundfläche-zu-Höhe-Verhältnis") gebildet werden, das im Mittel größer oder gleich 0,1 und besonders bevorzugt größer oder gleich 0,15 ist. Nimmt man eine prismen- oder pyramidenartige Form eines oder mehrerer Rückstände an, so weist die Form idealerweise besonders bevorzugt eine Spitze mit einem Winkel von etwa 90° oder größer auf, wobei die Spitze nicht mathematisch streng ausgeformt sein muss sondern beispielsweise auch abgerundet sein kann.

Die Strahlungsauskoppelschicht kann im Verfahrensschritt B mit einer Dicke von größer oder gleich 30 Nanometer und kleiner oder gleich 30 Mikrometer und besonders bevorzugt eine Dicke von größer oder gleich 300 Nanometer und kleiner oder gleich 3 Mikrometer aufweisen. Die Dicke der Strahlungsauskoppelschicht kann dabei bemessen sein von der Oberfläche der transparenten Schicht mit zu einer mittleren Höhe der Oberflächenstruktur über der Oberfläche der transparenten Schicht.

Insbesondere können ein oder mehrere Materialien aus einer Gruppe zur Erzeugung der Strahlungsauskoppelschicht aufgesprüht werden, die gebildet wird durch Acrylat, insbesondere ein Methacrylat und/oder ein Methylmethacrylat, Silikon, Epoxid, Polycarbonat und Naturplastik wie etwa Kautschuk sowie Vorstufen und/oder Kombinationen der genannten Materialien. Dazu kann vor dem Verfahrensschritt wie oben beschrieben eine Flüssigkeit bereitgestellt werden, die Monomere, Oligomere und/oder bereits teilvernetzte Polymere der genannten Materialien in Lösung, Suspension und/oder Emulsion aufweist. Dazu können die genannten Materialien in flüssiger und/oder fester Form in der Flüssigkeit vorliegen und besonders bevorzugt unter Energiezufuhr wie etwa Licht, insbesondere UV-Licht, und/oder Wärme und/oder mittels eines chemischen Prozesses vernetzbar und aushärtbar sind.

Als Lösungsmittel, Suspensionsmedium und/oder Emulgator können prinzipiell alle bekannten Flüssigkeiten dienen, die geeignet sind, die vorab genannten Materialien zu lösen, zu suspendieren und/oder zu emulgieren.

Beispielsweise kann im Verfahrensschritt B ein Material aufgesprüht werden, das hinsichtlich seiner Beschaffenheit und seiner optischen Eigenschaften glasartig ist. Das kann bedeuten, dass die Strahlungsauskoppelschicht in einem fertig gestellten Zustand eine amorphe, nicht-kristalline Struktur aufweist. Alternativ oder zusätzlich kann auch ein Material aufgebracht werden, das nach dem Fertigstellen der Strahlungsauskoppelschicht zumindest in den einzelnen Rückständen eine kristalline oder zumindest teilkristalline Struktur bildet. Die Strahlungsauskoppelschicht kann damit beispielsweise eine kristalline oder eine polykristalline Struktur aufweisen.

Weiterhin kann im Verfahrensschritt B ein Material aufgesprüht werden, das einen Brechungsindex aufweist, der kleiner oder gleich dem Brechungsindex der transparenten Schicht und größer als der Brechungsindex von Luft ist. Durch die Strahlungsauskoppelschicht mit diesem Material kann die Auskoppeleffizienz der in der organischen strahlungsemittierenden Schichtenfolge erzeugten elektromagnetischen Strahlung durch beispielsweise durch Verminderung von Totalreflexion an der Grenzfläche zwischen der transparenten Schicht und der Strahlungsauskoppelschicht verbessert werden.

Erfindungsgemäß werden zumindest zwei verschiedene Materialien aufgesprüht, die anschließend auf der Oberfläche der transparenten Schicht verbleiben. Die zumindest zwei verschiedenen Materialien werden dabei aus zwei verschiedenen Düsen als Lösungen, Suspensionen und/oder Emulsionen oder alternativ auch aus einer einzigen Düse in flüssiger Phase, einer Suspension oder einer Emulsion von Lösungen aufgebracht, die ineinander unlöslich sind. Dadurch kann beispielsweise beim Trocknen und/oder gegebenenfalls beim Aushärten eine Phasentrennung beziehungsweise Phasenseparation der zumindest zwei Materialien auftreten, was beispielsweise zur gezielten Einstellung von gewünschten Eigenschaften wie etwa lateral alternierende optische Eigenschaften der Strahlungsauskoppelschicht genutzt werden kann.

Weiterhin umfasst der Verfahrensschritt B folgende Teilschritte :
B1) Aufsprühen eines ersten Materials auf die der zumindest einen funktionellen Schicht abgewandten Oberfläche der transparenten Schicht und
B2) Aufsprühen eines zweiten Materials auf das erste Material oder Aufsprühen von zumindest zwei Materialien, die ineinander unlöslich sind.

Dadurch kann die Strahlungsauskoppelschicht mit zumindest zwei Schichten hergestellt werden, wobei die erste Schicht das erste Material und die zweite Schicht das zweite Material aufweist. Dabei kann jede der Schichten gemäß der obigen Beschreibung eine Oberflächenstruktur durch das Trocknen der aufgesprühten Tropfen des ersten beziehungsweise des zweiten Materials aufweisen. Das erste Material und das zweite Material können dabei gleich oder verschieden sein. Zusätzlich können in weiteren Teilschritten des Verfahrensschritts B weitere Materialien nacheinander auf dem zweiten Material aufgebracht werden.

Das erste Material kann dabei beispielsweise einen Brechungsindex aufweisen, der kleiner oder gleich dem Brechungsindex der transparenten Schicht und größer als der Brechungsindex des zweiten Materials ist, während der Brechungsindex des zweiten Materials wiederum größer als der Brechungsindex von Luft ist. Durch eine derartige "Brechungsindexkaskade" kann die Auskoppeleffizienz der in der organischen strahlungsemittierenden Schichtenfolge erzeugten elektromagnetischen Strahlung durch die Strahlungsauskoppelschicht weiter erhöht werden.

Weiterhin kann im Verfahrensschritt B ein Material zur Bildung der Strahlungsauskoppelschicht aufgebracht werden, das zusätzlich Streupartikel aufweist. Die Streupartikel können nach dem Trocknen und gegebenenfalls nach dem Aushärten des Materials in einem als Matrixmaterial dienenden oben genannten Material als Volumenstreuer dispergiert sein Insbesondere können die Streupartikel beispielsweise ein Metalloxid, so etwa Titanoxid oder Aluminiumoxid wie etwa Korund, und/oder Glaspartikel und/oder Kunststoffpartikel, die einen vom Matrixmaterial unterschiedlichen Brechungsindex aufweisen, umfassen. Weiterhin können die Streupartikel Hohlräume aufweisen und beispielsweise in Form von Kunststoffhohlkugeln ausgeführt sein. Die Streupartikel können dabei Durchmesser oder Korngrößen von weniger als einem Mikrometer bis zu einer Größenordnung von 10 Mikrometer oder auch bis zu 100 Mikrometer aufweisen.

Weiterhin kann im Verfahrensschritt B die Strahlungsauskoppelschicht lateral strukturiert auf der Oberfläche der transparenten Schicht aufgebracht werden. Beispielsweise kann dabei auch die transparente Schicht und/oder die organische strahlungsemittierende Schichtenfolge strukturiert sein, etwa in Form eines Displays oder einer Anzeige von Piktogrammen. Das lateral strukturierte Aufbringen der Strahlungsauskoppelschicht kann beispielsweise durch Aufsprühen durch eine Schattenmaske hindurch erfolgen. Alternativ dazu kann das Material zur Erzeugung der Strahlungsauskoppelschicht großflächig aufgesprüht werden und anschließend strukturiert ausgehärtet werden, beispielsweise mittels einer Schattenmaske oder mittels eines Lasers. Anschließend kann nicht-gehärtetes Material entfernt werden.

Die Strahlungsauskoppelschicht kann im Verfahrensschritt B beispielsweise streifenförmig, netz- beziehungsweise gitterförmig oder bildpunktförmig lateral strukturiert werden.

Weiterhin sind auch alle Kombinationen der vorab genannten Materialien, Schichten und Anordnungen beziehungsweise Strukturen zur Erzeugung der Strahlungsauskoppelschicht möglich.

Das hier beschriebene Verfahren ermöglicht die Herstellung eines organischen strahlungsemittierenden Bauelements, bei dem eine Strahlungsauskoppelschicht mit einer Oberflächenstruktur erzeugt wird, die die in der organischen strahlungsemittierenden Schichtenfolge erzeugte elektromagnetische Strahlung möglichst effizient aus den organischen funktionellen Schichten, einer transparenten Elektrode, einem transparenten Substrat und/oder einer transparenten Verkapselung auskoppeln kann.

Insbesondere ist das hier beschriebene Verfahren mit dem Aufbringen der Strahlungsauskoppelschicht mittels Aufsprühen gut skalierbar und auch für große Flächen anwendbar und bietet die Möglichkeit, möglichst raue Oberflächen mit Rauhigkeiten in den oben genannten Größenbereichen schnell, technisch einfach und großflächig aufzubringen. Das aufzusprühende Material kann in den oben genannten Grenzen frei wählbar sein. Insbesondere kann auch ein Wechsel zwischen zwei Materialen sehr schnell erfolgen. Beispielsweise die vorab genannten Streupartikel oder andere feste Materialien, die sich in Lösung oder Suspension vor dem Aufsprühen befinden, werden rein statistisch verteilt, was wie oben beschrieben die Streu- und Auskoppelwirkung der Strahlungsauskoppelschicht erhöhen und optimieren kann.

Zudem kann es möglich sein, die Strahlungsauskoppelschicht beispielsweise erst nach einer Qualitätskontrolle der im Verfahrensschritt A bereitgestellten organischen strahlungsemittierenden Schichtenfolge auf diese aufzubringen, was zu einer Senkung der Produktionskoten führen kann. Die Strahlungsauskoppelschicht kann dabei auch an die Qualität der organischen strahlungsemittierenden Schichtenfolge angepasst werden.

Weiterhin kann das hier beschriebene Verfahren neben der Herstellung von organischen strahlungsemittierenden Bauelementen für Beleuchtungszwecke auch für Anwendungen im Displaybereich vorteilhaft sein. Da wie bereit oben beschrieben durch das Aufsprühen Tropfen in einem geeignet ausgewählten und eingestellten Größenbereich von bevorzugt weniger als einem Mikrometer auf die Oberfläche der transparenten Schicht aufbringbar sind, können einzelne Pixel eines als Display ausgeführten organischen strahlungsemittierenden Bauelements mit typischen Abmessungen von etwa 100 Mikrometer mal 100 Mikrometer scharf und ohne ein "Ausfransen" der Pixelränder abgebildet werden. Würde man hier beispielsweise bekannte Mikrolinsen verwenden, die üblicherweise nicht kleiner als mit einem typischen Durchmesser von etwa 30 Mikrometer herstellbar sind, könnte ein Rand eines Pixels direkt im Zentrum einer Linse liegen, während ein anderer Rand mit einer Linse bündig abschließt. Einen ähnlichen Effekt würde man auch mit einer aufgerakelten Streuschicht aufgrund der dort üblicherweise erreichbaren Strukturgrößen erhalten. Dies würde aber zu einem ungleichmäßigen und unterschiedlichen optischen Eindruck bei einem externen Betrachter führen und wäre somit nicht wünschenswert. Gerade durch die durch das Aufsprühen erreichbare Auflösung in den vorab genannten Größenbereichen, die eher mit einem hochauflösenden Lithographieverfahren, jedoch ohne die dafür zusätzlichen aufwändigen und kostenintensiven Verfahrensschritte, vergleichbar ist, kann dieser Nachteil vermieden werden.

Beispielsweise umfasst ein organisches strahlungsemittierendes Bauelement insbesondere - eine organische strahlungsemittierende Schichtenfolge mit zumindest einer organischen funktionellen Schicht, die geeignet ist, im Betrieb elektromagnetische Strahlung abzustrahlen, und einer transparenten Schicht und - eine Strahlungsauskoppelschicht auf einer der zumindest einen funktionellen Schicht abgewandten Oberfläche der transparenten Schicht,
wobei
- die Strahlungsauskoppelschicht eine Oberflächenstruktur gebildet aus Rückständen einer Mehrzahl individuell getrockneter Tropfen aufweist.

Dabei kann das organische strahlungsemittierende Bauelement insbesondere durch das vorab beschriebene Verfahren herstellbar sein und weiterhin hergestellt sein. Alle vorab in Verbindung mit dem Verfahren zur Herstellung des organischen strahlungsemittierenden Bauelements genannten Merkmale und Kombinationen daraus, Eigenschaften und Vorteile gelten daher auch für das organische strahlungsemittierende Bauelement. Umgekehrt gelten alle hier und im Folgenden in Verbindung mit dem organischen strahlungsemittierenden Bauelement genannten Merkmale, Merkmalskombinationen, Eigenschaften und Vorteile auch für das vorab genannte Verfahren.

Insbesondere kann die Strahlungsauskoppelschicht Rückstände aufweisen, die eine Größe von kleiner oder gleich 1 Mikrometer aufweisen. Weiterhin können die Rückstände eine prismenartige, pyramidenartige, eine meniskenartige Form oder eine Kombination daraus aufweisen. Die Rückstände können dabei bevorzugt ein Höhe-zu-Grundfläche-Verhältnis von größer oder gleich 0,1, besonders bevorzugt von größer oder gleich 0,15 aufweisen.

Weiterhin weist die Strahlungsauskoppelschicht eine erste Schicht mit einem ersten Material und eine zweite Schicht mit einem zweiten Material auf.

Weitere Vorteile und vorteilhafte Ausführungsformen und Weiterbildungen des Verfahrens und des organischen strahlungsemittierenden Bauelements ergeben sich aus den im Folgenden in Verbindung mit den Figuren 1A bis 6E beschriebenen Ausführungsformen.

Es zeigen:
Figuren 1A und 1B schematische Darstellungen von Verfahrensschritten eines Verfahrens zur Herstellung eines organischen strahlungsemittierenden Bauelements gemäß einem Ausführungsbeispiel,
Figuren 2A bis 2D schematische Darstellungen von Teilschritten eines Verfahrensschritts gemäß dem Ausführungsbeispiel,
Figur 3 eine schematische Darstellung eines Teilschritts eines Verfahrensschritts gemäß einem weiteren Ausführungsbeispiel,
Figur 4 eine schematische Darstellung eines organischen strahlungsemittierenden Bauelements,
Figur 5 eine schematische Darstellung eines Verfahrensschritts,
Figuren 6 und 7 schematische Darstellungen von organischen strahlungsemittierenden Bauelementen gemäß weiteren Ausführungsbeispielen, und
Figuren 8A bis 8C schematische Darstellungen von Verfahrensschritten gemäß einem weiteren Ausführungsbeispiel.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

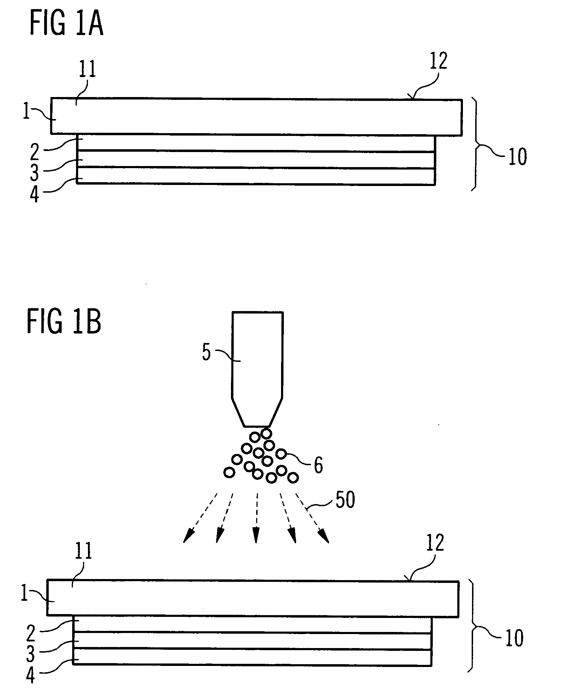

In den Figuren 1A und 1B sind Verfahrensschritte eines Verfahrens zur Herstellung eines organischen strahlungsemittierenden Bauelements gemäß einem Ausführungsbeispiel gezeigt.

Dabei wird in einem ersten Verfahrensschritt A gemäß Figur 1A eine organische strahlungsemittierende Schichtenfolge 10 bereitgestellt. Die organische strahlungsemittierende Schichtenfolge 10 ist im gezeigten Ausführungsbeispiel eine als so genannter Bottom-Emitter ausgeführte organische Leuchtdiode (OLED). Die organische strahlungsemittierende Schichtenfolge 10 weist dazu eine Substrat 1 auf, auf dem eine erste Elektrode2, eine organische funktionelle Schicht 3 und eine zweite Elektrode 4 aufgebracht sind.

Das Substrat 1 ist im gezeigten Ausführungsbeispiel aus Glas und transparent ausgebildet. Die erste Elektrode 2 ist aus Indium-Zinn-Oxid (ITO) und als transparente Anode ausgebildet. Die zweite Elektrode 4 weist ein Metall mit einer geringen Austrittsarbeit für Elektronen auf und ist im gezeigten Ausführungsbeispiel als Kathode mit einer Aluminiumschicht ausgebildet.

Die organische funktionelle Schicht 3 weist ein organisches elektrolumineszierendes Material auf und ist geeignet, im Betrieb des herzustellenden organischen strahlungsemittierenden Bauelements elektromagnetische Strahlung durch Rekombination von Elektronen und Löchern zu erzeugen, die jeweils von der zweiten Elektrode 4 beziehungsweise von der ersten Elektrode 2 in die organische funktionelle Schicht 3 injiziert werden. Zusätzlich zur gezeigten organischen funktionellen Schicht 3 kann die organische strahlungsemittierende Schichtenfolge 10 noch weitere organische funktionelle Schichten aufweisen, etwa eine oder mehrere Lochtransportschichten und/oder eine oder mehrere Elektronentransportschichten und/oder eine oder mehrere Ladungsträgerblockierschichten, die der Übersichtlichkeit halber nicht dargestellt sind.

Die organische strahlungsemittierende Schichtenfolge 10 weist eine transparente Schicht 11 auf, die im gezeigten Ausführungsbeispiel durch das Substrat 1 gebildet wird und die eine der zumindest einen funktionellen Schicht 3 abgewandte Oberfläche 12 aufweist. Von der Oberfläche 12 der transparenten Schicht 11 kann die in der organischen funktionellen Schicht 3 erzeugte elektromagnetische Strahlung aus der organischen strahlungsemittierenden Schichtenfolge 10 abgestrahlt werden.

Die hier und im Folgenden gezeigte organische strahlungsemittierende Schichtenfolge 10 ist hinsichtlich ihrer Ausführung rein beispielhaft und nicht beschränkend auszulegen. Alternativ oder zusätzlich zum gezeigten Ausführungsbeispiel kann die organische strahlungsemittierende Schichtenfolge 10 einen alternativen Schichtaufbau und/oder Materialien wie im allgemeinen Teil beschrieben aufweisen sowie eine Verkapselung. Alternativ zum gezeigten Ausführungsbeispiel kann die organische strahlungsemittierende Schichtenfolge 10 auch als so genannter Top-Emitter ausgeführt sein, bei dem die transparente Schicht 11 durch die dem Substrat 1 abgewandte Elektrode 4 und/oder durch eine Verkapselung (nicht gezeigt) gebildet wird.

Die folgenden Verfahrensschritte und Ausführungsbeispiele beziehen sich gleichermaßen auf eine als großflächige Beleuchtungseinrichtung oder als strukturierte Anzeige wie etwa ein Display ausgeführte organische strahlungsemittierende Schichtenfolge 10.

In Figur 1B ist ein weiterer Verfahrensschritt B gezeigt, bei dem eine Flüssigkeit auf die Oberfläche 12 der transparenten Schicht 11 aufgesprüht wird. Dazu wird eine Düse 5 bereitgestellt, die die Flüssigkeit in Form von Tropfen 6 entlang einer Aufsprührichtung, die durch die Pfeile 50 angedeutet ist, auf der Oberfläche 12 aufsprüht.

Die Größe der einzelnen Tropfen 6 ist dabei durch eine statistische Verteilung von Tropfengrößen um eine mittlere Größe herum gegeben und hängt von der Düse 5 sowie von den Eigenschaften der Flüssigkeit ab. Durch gezielte Wahl der Düsenparameter wie etwa der Größe der Düsenöffnung und/oder der Austrittsgeschwindigkeit der Tropfen 6 aus der Düsenöffnung in Verbindung mit Eigenschaften der Flüssigkeit wie etwa deren Viskosität und/oder deren Bestandteile in Form von Materialien und Gemischen in flüssiger Phase, in Form einer Lösung, einer Suspension und/oder einer Emulsion sind ein gewünschter Größenbereich und eine gewünschte Größenverteilung der Tropfen einstellbar. Die einzelnen Tropfen weisen im gezeigten Ausführungsbeispiel bevorzugt eine Größe und insbesondere einen Durchmesser von größer oder gleich 200 Nanometer und kleiner oder gleich 1 Mikrometer auf.

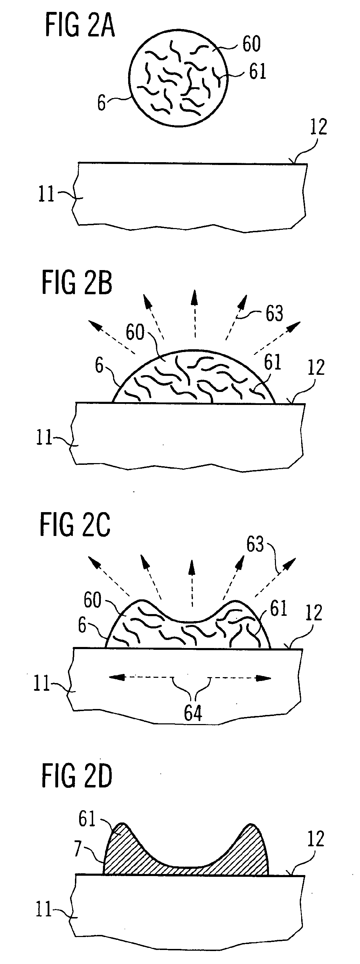

In den Figuren 2A bis 2D sind Teilschritte und weitere Merkmale des Verfahrensschritts B anhand eines rein beispielhaft gezeigten Tropfens 6 gezeigt. Dabei ist in den Figuren 2A bis 2D jeweils ein Ausschnitt der organischen strahlungsemittierenden Schichtenfolge 10 aus den Figuren 1A und 1B gezeigt, in dem lediglich die transparente Schicht 11 dargestellt ist.

Dabei ist in Figur 2A der Tropfen 6 kurz vor dem Auftreffen auf die Oberfläche 12 der transparenten Schicht 11 gezeigt. Der Tropfen 6 weist ein Material 61 auf, das in einem flüssigen Medium 60 gelöst ist. Das Material 61 ist im gezeigten Ausführungsbeispiel ein in Form von Monomeren, Oligomeren und/oder teilvernetzten Polymeren vorliegender transparenter Kunststoff auf Acrylat-Basis, der in dem als Lösungsmittel ausgeführten flüssigen Material 60 gelöst ist. Weiterhin können das Material 61 und/oder das flüssige Medium 60 weitere Bestandteile und Hilfsstoffe aufweisen, die die Lösbarkeit des Materials 61 im flüssigen Medium 60 und/oder die Vernetzbarkeit des Materials 61 verbessern können und die dem Fachmann beispielsweise von Lacken her bekannt sind.

Alternativ dazu kann das Material 61 auch selbst in einer flüssigen Phase mit oder ohne das flüssige Medium 60 vorliegen und/oder mit dem flüssigen Medium eine Suspension oder Emulsion bilden. Das Material 61 kann weiterhin alternativ oder zusätzlich eines oder mehrere der im allgemeinen Teil genannten Materialien und/oder Eigenschaften aufweisen.

Der Tropfen 6 weist im vorliegenden Ausführungsbeispiel somit als flüchtigen Bestandteil das flüssige Medium 60 und als nicht-flüchtigen Bestandteil das Material 61 auf.

In Figur 2B ist der Tropfen 6 kurz nach dem Auftreffen auf die Oberfläche 12 der transparenten Schicht 11 gezeigt. Aufgrund der Oberflächenspannung des Tropfens 6 stellt sich dabei eine charakteristische Wölbung des Tropfens 6 auf der Oberfläche 12 ein. Dabei wird durch die Oberflächenspannung des Tropfens 6 auch die Verdampfungsrate des flüssigen Mediums 60 bestimmt. Durch das Verdampfen des flüssigen Mediums 60, das durch die Pfeile 63 angedeutet ist, trocknet der Tropfen 6 im Sinne der Beschreibung im allgemeinen Teil individuell und unabhängig von weiteren auf die Oberfläche 12 aufgesprühten Tropfen.

Im gezeigten Ausführungsbeispiel sind die Bestandteile des Tropfens 6 derart gewählt, dass in den Randbereichen des Tropfens 6 auf der Oberfläche 12 die Verdunstungsbeziehungsweise Verdampfungsrate des flüssigen Mediums 60 höher ist als in der Mitte des Tropfens 6. Dadurch verflüchtigt sich das flüssige Medium 6 in den Randbereichen des Tropfens 6 schneller als in der Mitte, wodurch aus der Mitte flüssiges Medium 60 zu den Randbereichen nachströmt und eine Diffusionsbewegung des im flüssigen Medium 60 gelösten Materials 61 bewirkt wird, was in Figur 2C durch die Pfeile 64 angedeutet ist. Im Laufe des Trocknungsprozesses des Tropfens 6 sammelt sich somit in den Randbereichen des Tropfens 6 im Vergleich zur Mitte eine größere Menge des Materials 61 an, was auch als so genannter Marangoni- oder Kaffeefleckeffekt bezeichnet werden kann.

Ist das flüssige Medium 60 gänzlich verflüchtigt, bleibt wie in Figur 2D gezeigt ein Rückstand 7 auf der Oberfläche 12 der transparenten Schicht 11 zurück, der das Material 61 aufweist. Der Rückstand 7 des individuell getrockneten Tropfens 6 weist eine meniskusartige Form mit einer im Vergleich zur Mitte erhabenen Randbereich auf. Das Verhältnis der Höhe des Rückstands 7 zu dessen Grundfläche auf der Oberfläche 12 kann dabei durch geeignete Wahl der Bestandteile des Tropfens 6 größer oder gleich 0,1 betragen und ist im gezeigten Ausführungsbeispiel größer oder gleich 0,15.

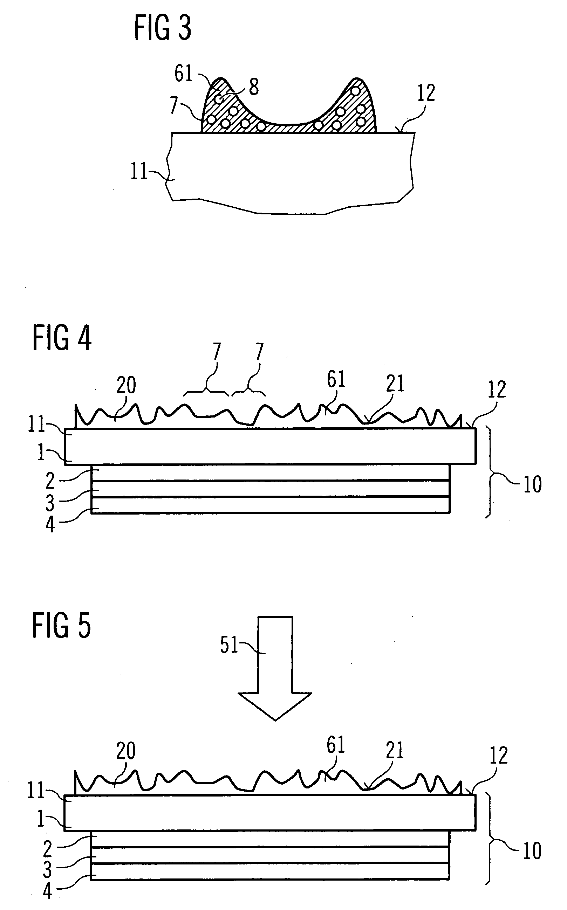

In Figur 3 ist ein Rückstand 7 gemäß einem weiteren Ausführungsbeispiel gezeigt, bei dem gemäß den Figuren 1B bis 2C eine Flüssigkeit in Form von Tropfen 6 aufgesprüht wurde, bei denen das Material 61 zusätzlich noch Streupartikel 8 aufweist. Der Rückstand 7 gemäß Figur 3 weist ebenso das Material 61 in einer meniskusartigen Form auf, das gleichzeitig als Matrixmaterial für die Streupartikel 8 dient. Im gezeigten Ausführungsbeispiel sind die Streupartikel 8 als Kunststoffhohlkugeln mit einer Größe von weniger als einigen hundert Nanometern ausgeführt, die einen vom Material 61 verschiedenen Brechungsindex aufweisen.

Wird auf die Oberfläche 12 der transparenten Schicht 11 ein weiterer Tropfen 6 gemäß der vorherigen Beschreibung aufgesprüht, so kann dieser beispielsweise den Rückstand 7 der Figuren 2D oder 3 teilweise überdecken oder zumindest an diesen angrenzen. Dadurch stellt sich beim Trocknen dieses Tropfens 6 aufgrund des schon vorhandenen Rückstands 7 und dessen Form eine individuelle meniskusartige Form ein, die verschieden von der Form des gezeigten Rückstands 7 ist. Dieser Effekt wird noch zusätzlich dadurch verstärkt, dass der weitere Tropfen eine andere Größe als der vorher aufgebracht aufweisen kann. Dadurch kann durch das Aufsprühen eine unregelmäßige Anordnung von Rückständen 7 auf der Oberfläche 12 der transparenten Schicht 11 erzeugt werden.

In Figur 4 ist ein organisches strahlungsemittierendes Bauelement gezeigt, dass auf der Oberfläche 12 der transparenten Schicht 11 eine Strahlungsauskoppelschicht 20 aufweist, die durch die individuell getrockneten Rückstände 7 der aufgesprühten Tropfen 6 gemäß der vorhergehenden Beschreibung gebildet ist. Durch das vorab beschriebene Trocknen der Rückstände 7, von denen zwei rein beispielhaft gekennzeichnet sind, ergibt sich dabei die rein exemplarisch gezeigte Oberflächenstruktur 21 der Strahlungsauskoppelschicht 20. Jeweils benachbarte oder teilweise überlappende Rückstände 7 bilden Strukturen mit prismen- oder pyramidenartigen Formen aus, die im Vergleich zu anderen im allgemeinen Teil erwähnten Verfahren eine größere Unregelmäßigkeit und Rauhigkeit bei einer mittleren Größe von weniger als 1 Mikrometer aufweisen.

Insbesondere sei darauf hingewiesen, dass hier und in den folgenden Figuren die Größe der Oberflächenstruktur 21 im Vergleich zur Ausdehnung der organischen strahlungsemittierenden Schichtenfolge 10 der Übersichtlichkeit halber übertrieben groß dargestellt ist. Die derart aufgesprühte Strahlungsauskoppelschicht 20 weist eine Dicke zwischen 30 Nanometer und 30 Mikrometer und besonders bevorzugt zwischen 300 Nanometer und 3 Mikrometer auf, wobei die Grenzen jeweils mit eingeschlossen sind.

Das Material 61 der Strahlungsauskoppelschicht 20 weist im gezeigten Beispiel einen Brechungsindex auf, der kleiner oder gleich dem Brechungsindex der transparenten Schicht 11 der organischen strahlungsemittierenden Schichtenfolge 10 und größer als der Brechungsindex von Luft ist. Dadurch und durch die unregelmäßige und raue Oberflächenstruktur 21 der Strahlungsauskoppelschicht 20 kann die Auskopplung der in der organischen funktionellen Schicht 3 erzeugten elektromagnetischen Strahlung im Vergleich zu einer herkömmlichen OLED ohne die hier beschriebene Strahlungsauskoppelschicht 20 wesentlich erhöht werden.

Weist das Material 61 wie in Figur 3 gezeigt noch Streupartikel 8 auf, so können diese als Volumenstreuer wirken und die Auskoppeleffizienz noch weiter erhöhen. Die Streupartikel 8 sind durch das Aufsprühen ebenfalls unregelmäßig und rein statistisch verteilt.

Durch die große Unregelmäßigkeit der Oberflächenstruktur 21 und gegebenenfalls durch die Streupartikel 8 werden durch die hier beschriebene Strahlungsauskoppelschicht 20 störende Moire-Effekte vermieden, was eine große Homogenität der abgestrahlten Leuchtintensität ermöglichen kann. Besonders bevorzugt weist in diesem Zusammenhang auch das Material 61 selbst eine amorphe, glasartige Struktur auf.

In Figur 5 ist ein weiterer Verfahrensschritt beispielhaft gezeigt, bei dem das Material 61 der Strahlungsauskoppelschicht 20 beziehungsweise der diese bildenden Rückstände vernetzt wird. Dabei wird das Material 61 durch einen externen Energieeintrag, angedeutet durch den Pfeil 51, beispielsweise in Form von UV- oder Wärmestrahlung vernetzt und dadurch ausgehärtet. Alternativ dazu kann der Energieeintrag auch während des Verfahrensschritts B gemäß Figur 1B sowie den Figuren 2A bis 2D erfolgen, so dass die Rückstände 7 der Tropfen 6 individuell gehärtet werden.

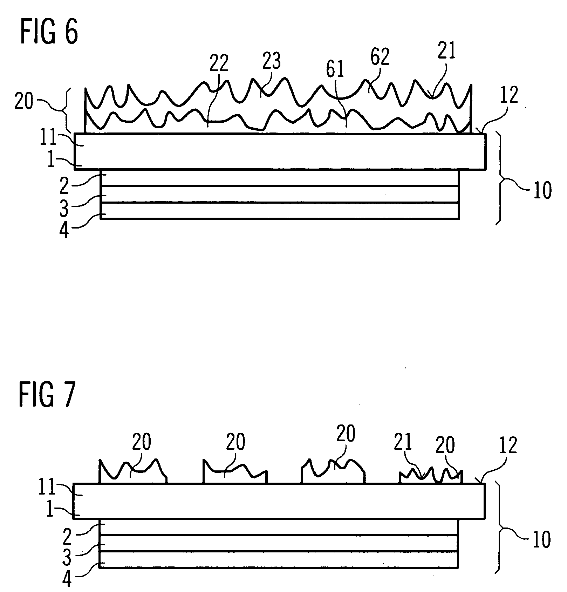

In Figur 6 ist ein organisches strahlungsemittierendes Bauelement gemäß einem weiteren Ausführungsbeispiel gezeigt, das eine Strahlungsauskoppelschicht 20 mit einer ersten Schicht 22 und einer zweiten Schicht 23 aufweist. Die erste Schicht 22 weist dabei ein erstes Material 61 auf und wird beispielsweise gemäß der vorherigen Beschreibung in einem Teilschritt B1 des Verfahrensschritts B aufgesprüht. Die zweite Schicht 23 weist ein zweites Material 62 auf, das mittels eines zweiten Teilschritts B2 des Verfahrensschritts B auf der ersten Schicht 22 aufgesprüht wird. Die der transparenten Schicht 11 abgewandte Oberfläche der zweiten Schicht 23 weist die Oberflächenstruktur 21 der Strahlungsauskoppelschicht 20 auf.

Das zweite Material 62 der zweiten Schicht 23 weist einen kleineren Brechungsindex als das erste Material 61 der ersten Schicht 22 auf, während das erste Material 61 einen kleineren Brechungsindex als die transparente Schicht 11 der organischen strahlungsemittierenden Schichtenfolge 10 aufweist. Durch eine derartige "Brechungsindexkaskade" in Verbindung mit den jeweiligen Oberflächenstrukturen der ersten Schicht 22 und der zweiten Schicht 23 kann die Wahrscheinlichkeit für Totalreflexion an Grenzflächen zwischen den genannten Schichten vermindert werden, wodurch die Auskoppeleffizienz weiter erhöht werden kann. Die Strahlungsauskoppelschicht 20 kann zusätzlich zur ersten Schicht 22 und zur zweiten Schicht 23 noch weitere Schichten aufweisen, die durch Aufsprühen aufeinander aufgebracht werden und die ebenfalls eine Brechungsindexkaskade bilden.

In Figur 7 ist ein organisches strahlungsemittierendes Bauelement gemäß einem weiteren Ausführungsbeispiel gezeigt, das eine strukturierte Strahlungsauskoppelschicht 20 aufweist. Dabei werden die Tropfen in Verfahrensschritt B durch eine Schattenmaske aufgesprüht. Alternativ dazu können die Tropfen auch großflächig und unstrukturiert aufgesprüht werden und die getrockneten Rückstände können anschließend durch eine Schattenmaske hindurch beispielsweise mittels UV-Licht vernetzt werden. Unvernetzte Bereiche der Rückstände 7 werden dann anschließend entfernt.

Die organische strahlungsemittierende Schichtenfolge 10 im gezeigten Ausführungsbeispiel ist als Display mit einzelnen Bildpunkten beziehungsweise Pixeln ausgeführt. Die strukturierte Strahlungsauskoppelschicht 20 weist lediglich über den Pixeln Rückstände der aufgesprühten Tropfen auf, so dass die Auskopplung der abgestrahlten elektromagnetischen Strahlung eines jeden Pixels optimiert werden kann, ohne dass die Pixelgrenzen durch die Oberflächenstruktur 21 einer unstrukturierten Strahlungsauskoppelschicht 20 verschmiert werden.

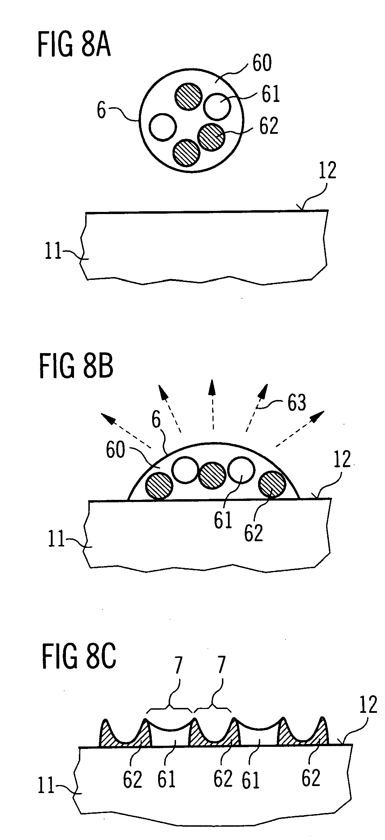

In den Figuren 8A bis 8C sind Teilschritte des Verfahrensschritts B ähnlich wie in den Figuren 2A bis 2D gemäß einem weiteren Ausführungsbeispiel gezeigt.

Die auf die Oberfläche 12 aufgesprühten Tropfen 6, von denen in Figur 8A einer exemplarisch gezeigt ist, weisen ineinander unlösbare Lösungen mit Materialien 61 und 62 auf, die gleichzeitig in Form einer Emulsion in einem flüssigen Material 60, dass beispielsweise einen Emulgator aufweisen kann, aufgesprüht werden.

Nach dem Auftreffen auf die Oberfläche 12 gemäß Figur 8B trocknen die ineinander unlösbaren Lösungen mit den Materialien 61 und 62 individuell und unabhängig voneinander. Dabei verflüchtigen sich das flüssige Medium 60 sowie die Lösungsmittel der Materialien 61 und 62, wie durch die Pfeile 63 angedeutet ist.

Wie in Figur 8C gezeigt ist, bildet jeweils jeder der Bereiche mit dem Material 61 und mit dem Material 62 einen eigenen Rückstand 7 aus, der beispielsweise gemäß der vorherigen Beschreibung durch den Marangoni-Effekt beim Trocknen eine meniskusartige Form aufweisen kann. Dadurch ist eine Strahlungsauskoppelschicht herstellbar, die durch die beschriebene Phasenseparation der Materialien 61 und 62 lateral alternierende optische Eigenschaften aufweisen kann.

Alternativ zum gezeigten Ausführungsbeispiel können die ineinander unlösbaren Materialien 61 und 62 auch gleichzeitig aus zwei verschiedenen Düsen aufgesprüht werden.

Die gezeigten Verfahrensschritte und Merkmale der beschriebenen Ausführungsbeispiele sowie der im allgemeinen Teil beschriebenen Ausführungsformen sind weiterhin auch miteinander kombinierbar, um eine optimale Auskoppeleffizienz durch die Strahlungsauskoppelschicht 20 zu erreichen.

## Patentansprüche

1. Verfahren zur Herstellung eines organischen strahlungsemittierenden Bauelements, umfassend die Schritte:
A) Bereitstellen einer organischen strahlungsemittierenden Schichtenfolge (10) mit zumindest einer organischen funktionellen Schicht (3), die geeignet ist, im Betrieb elektromagnetische Strahlung abzustrahlen, und einer transparenten Schicht (11),
B) Aufbringen einer transparenten Strahlungsauskoppelschicht (20) mit einer Oberflächenstruktur (21) auf einer der zumindest einen funktionellen Schicht (3) abgewandten Oberfläche (12) der transparenten Schicht (11) mittels Aufsprühen,
**dadurch gekennzeichnet, dass**
- der Verfahrensschritt B folgende Teilschritte umfasst:
B1) Aufsprühen eines ersten Materials (61) und
B2) Aufsprühen eines zweiten Materials (62) auf das erste Material (61)
oder
- dass im Verfahrensschritt B zumindest zwei Materialien (61, 62) aufgebracht werden, die ineinander unlöslich sind.

2. Verfahren nach Anspruch 1, bei dem
- im Verfahrensschritt B die Strahlungsauskoppelschicht (20) in Form von einzelnen Tropfen (6) aufgesprüht wird, die individuell auf der Oberfläche (12) der transparenten Schicht (11) unter Ausbildung der Strahlungsauskoppelschicht (20) trocknen.

3. Verfahren nach Anspruch 2, bei dem
- im Verfahrensschritt B ein vernetzbares Material (61) in einer flüssigen Phase, einer Lösung, einer Suspension oder eine Kombination daraus in Form von Tropfen (6) aufgebracht wird, wobei mittels Trocknern (63) und/oder Vernetzen des Materials (61) die Strahlungsauskoppelschicht (20) gebildet wird.

4. Verfahren nach einem der Ansprüche 2 oder 3, bei dem
- die Tropfen (6) beim Trocknen (63) Rückstände (7) mit einer prismenartigen, pyramidenartigen, eine meniskenartigen Form oder einer Kombination daraus ausbilden.

5. Verfahren nach einem der vorherigen Ansprüche, bei dem
- im Verfahrensschritt B eines oder mehrere Materialien (61, 62) aus einer Gruppe aufgesprüht werden, die gebildet wird durch Acrylat, Silikon, Epoxid, Polycarbonat, Naturplastik.

6. Verfahren nach einem der vorherigen Ansprüche, bei dem
- im Verfahrensschritt B ein Material (61) aufgesprüht wird, das Streupartikel (8) aufweist.

7. Verfahren nach einem der vorherigen Ansprüche, bei dem
- im Verfahrensschritt B die Strahlungsauskoppelschicht (20) lateral strukturiert auf der Oberfläche (12) der transparenten Schicht (11) aufgebracht wird.

## Claims

1. Method for producing an organic radiation-emitting component, comprising the following steps:
A) providing an organic radiation-emitting layer sequence (10) having at least one organic functional layer (3) suitable for emitting electromagnetic radiation during operation, and a transparent layer (11),
B) applying a transparent radiation coupling-out layer (20) having a surface structure (21) on a surface (12) of the transparent layer (11) which is remote from the at least one functional layer (3) by means of spray coating,
**characterized in that**
- method step B comprises the following substeps:
B1) applying a first material (61) by spray coating, and
B2) applying a second material (62) to the first material (61) by spray coating,
or
- **in that**, in method step B, at least two materials (61, 62) which are insoluble in one another are applied.

2. Method according to claim 1, wherein
- in method step B, the radiation coupling-out layer (20) is applied by spray coating in the form of individual drops (6) which dry individually on the surface (12) of the transparent layer (11) to form the radiation coupling-out layer (20).

3. Method according to claim 2, wherein
- in method step B a crosslinkable material (61) in a liquid phase, a solution, a suspension or a combination thereof is applied in the form of drops (6), wherein the radiation coupling-out layer (20) is formed by means of drying (63) and/or crosslinking of the material (61).

4. Method according to either of claims 2 and 3, wherein
- the drops (6) form during drying (63) residues (7) having a prism-like, pyramid-like, meniscus-like form or a combination thereof.

5. Method according to any of the preceding claims, wherein
- in method step B, one or a plurality of materials (61, 62) from a group formed by acrylate, silicone, epoxide, polycarbonate, natural plastic is or are applied by spray coating.

6. Method according to any of the preceding claims, wherein
- in method step B, a material (61) comprising scattering particles (8) is applied by spray coating.

7. Method according to any of the preceding claims, wherein
- in method step B, the radiation coupling-out layer (20) is applied in a laterally structured fashion on the surface (12) of the transparent layer (11).

## Revendications

1. Procédé pour la fabrication d'un composant organique émettant un rayonnement, comprenant les étapes consistant à :
A) mettre à disposition une succession de couches (10), organique, émettant un rayonnement, présentant au moins une couche (3) fonctionnelle organique qui est appropriée pour émettre un rayonnement électromagnétique lors du fonctionnement ainsi qu'une couche (11) transparente,
B) appliquer par pulvérisation une couche (20) de sortie de rayonnement, transparente, présentant une structure superficielle (21) sur une surface (12), opposée à ladite au moins une couche (3) fonctionnelle, de la couche (11) transparente, **caractérisé en ce que**
- l'étape de procédé B comprend les étapes partielles suivantes, consistant à :
B1) pulvériser un premier matériau (61) et
B2) pulvériser un deuxième matériau (62) sur le premier matériau (61)
ou
- **en ce qu'**au moins deux matériaux (61, 62), qui sont insolubles l'un dans l'autre, sont appliqués dans l'étape de procédé B.

2. Procédé selon la revendication 1, dans lequel
- dans l'étape de procédé B, la couche (20) de sortie du rayonnement est pulvérisée sous forme de gouttes individuelles (6), qui sèchent individuellement sur la surface (12) de la couche (11) transparente avec formation de la couche (20) de sortie du rayonnement.

3. Procédé selon la revendication 2, dans lequel
- dans l'étape de procédé B, on applique un matériau (61) réticulable dans une phase liquide, une solution, une suspension ou une combinaison de celles-ci, sous forme de gouttes (6), la couche (20) de sortie du rayonnement étant formée par séchage (63) et/ou réticulation du matériau (61).

4. Procédé selon l'une quelconque des revendications 2 ou 3, dans lequel
- les gouttes (6) forment, lors du séchage (63), des résidus (7) présentant une forme de type prisme, de type pyramide, de type ménisque ou une combinaison de ceux-Ci.

5. Procédé selon l'une quelconque des revendications précédentes, dans lequel
- on pulvérise, dans l'étape de procédé B, un ou plusieurs matériaux (61, 62) d'un groupe qui est formé par l'acrylate, le silicone, l'époxyde, le polycarbonate, le plastique naturel.

6. Procédé selon l'une quelconque des revendications précédentes, dans lequel on pulvérise, dans l'étape de procédé B, un matériau (61) qui présente des particules de diffusion (8).

7. Procédé selon l'une quelconque des revendications précédentes, dans lequel,
- dans l'étape de procédé B, la couche (20) de sortie du rayonnement est appliquée avec une structuration latérale sur la surface (12) de la couche (11) transparente.
